# EUROPEAN PATENT APPLICATION

(11) **EP 4 657 414 A1**
(43) Date of publication of application: **03.12.2025**
(21) Application number: 24893133.9
(22) Date of filing: 22.10.2024
(51) Int. Cl.: G09F 9/33

(54) **DISPLAY MODULE, PREPARATION METHOD THEREFOR, AND DISPLAY APPARATUS**

(30) Priority: 23.11.2023 CN 202311577311
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: XIE, Linhong, Beijing 100176 (CN); CHEN, Yangyang, Beijing 100176 (CN); HU, Yan, Beijing 100176 (CN); LIN, Qili, Beijing 100176 (CN); ZHANG, Qiudong, Beijing 100176 (CN); CHEN, Yue, Beijing 100176 (CN); LIU, Yajie, Beijing 100176 (CN)
(74) Representative: Hoffmann Eitle
(86) International application number: PCT/CN2024/126584
(87) International publication number: WO 2025/107974

(57) **Abstract**

A display module, comprising: a display panel, the display panel comprising a display portion, a bending portion and a binding portion, connected in sequence, the binding portion comprising a first binding sub-portion and a first main body sub-portion connected to each other; a flexible circuit board, comprising a second binding sub-portion and a second main body sub-portion, connected to each other, an orthographic projection of the second binding sub-portion onto the display portion at least partially overlapping with an orthographic projection of the first binding sub-portion onto the display portion, and the second main body sub-portion being provided with a first opening; a chip, located in the first opening and electrically connected to the first main body sub-portion; a bonding layer, bonded between the first main body sub-portion and the second main body sub-portion; a first sealing portion, located in the first opening, the first sealing portion being connected to the bonding layer, the first main body sub-portion and the second main body sub-portion; a second sealing portion, located outside the first opening and connected to the bonding layer, the first binding sub-portion, the first main body sub-portion, the second binding sub-portion and the second main body sub-portion, orthographic projections of the first sealing portion, the bonding layer, the second sealing portion and the first binding sub-portion onto the display portion forming a closed shape.

## Description

This application claims priority to Chinese Patent Application No. 202311577311.X, filed on November 23, 2023, which is incorporated herein by reference in its entirety.

### TECHNICAL FIELD

The present disclosure relates to the field of display technologies, and in particular, to a display module and a method for manufacturing the same, and a display apparatus.

### BACKGROUND

The flexible display panel may be bent freely, so that the display apparatus with the flexible display panel may achieve more diversified structural forms, such as a folding form, a bending form, a sliding-rolling form and other forms. For example, a display apparatus in a sliding-rolling form may be unfolded or rolled up to a side by sliding, thereby achieving flexible adjustment of a size of a product screen without creases on the product screen. The display apparatus in a folding form or a sliding-rolling form is highly favored by users due to a great user experience brought by a flexibly adjustable size of the display panel (product screen).

### SUMMARY

In an aspect, a display module is provided. The display module includes a display panel, a flexible circuit board, a chip, adhesive layer(s), a first sealing portion and a second sealing portion. The display panel includes a display portion, a bending portion and a bonding portion connected in sequence. The display portion has a light-exit surface and a non-light-exit surface that are disposed opposite to each other, an end of the bending portion connected to the bonding portion is bent to the non-light-exit surface; the bonding portion is located on the non-light-exit surface; and the bonding portion includes a first bonding sub-portion and a first main body sub-portion that are connected to each other. The flexible circuit board includes a second bonding sub-portion and a second main body sub-portion that are connected to each other. An orthographic projection of the second bonding sub-portion on the display portion at least partially overlaps with an orthographic projection of the first bonding sub-portion on the display portion; and an orthographic projection of the second main body sub-portion on the display portion at least partially overlaps with an orthographic projection of the first main body sub-portion on the display portion. The second main body sub-portion has first opening(s). The chip is located in a first opening and electrically connected to the first main body sub-portion. The adhesive layer(s) are bonded between the first main body sub-portion and the second main body sub-portion, and located on at least one side of the chip. An adhesive layer and the first bonding sub-portion are located on different sides of the first opening. The first sealing portion is located in the first opening, at least part of the first sealing portion is located on a side of the chip proximate to the first bonding sub-portion; and the first sealing portion is connected to the adhesive layer and the first main body sub-portion. The second sealing portion is located outside the first opening and connected to the adhesive layer, the first bonding sub-portion, the first main body sub-portion, the second bonding sub-portion and the second main body sub-portion. Orthographic projections of the first sealing portion, the adhesive layer, the second sealing portion and the first bonding sub-portion on the display portion constitute a closed figure.

In some embodiments, a portion of the adhesive layer extends beyond a side wall of the first opening and extends into the first opening.

In some embodiments, a dimension of the portion of the adhesive layer extending beyond the first opening is in a range of 0.3 mm to 0.5 mm, inclusive.

In some embodiments, the adhesive layer has a cross-section in a U shape and surrounds the chip.

In some embodiments, the first opening(s) include a plurality of first openings, and adhesive layers corresponding to all first openings are connected to be of an integral structure.

In some embodiments, the second main body sub-portion further has a second opening, and the second sealing portion is located in the second opening and in contact with a side wall of the second opening.

In some embodiments, an orthographic projection of the adhesive layer on the display portion partially overlaps with an orthographic projection of the second sealing portion on the display portion.

In some embodiments, the first sealing portion is further connected to the chip.

In some embodiments, a fixing portion is located in the first opening, and the fixing portion is connected to the chip and the first main body sub-portion.

In some embodiments, the first sealing portion is connected to the fixing portion, and orthographic projections of the first sealing portion and the fixing portion on the display portion constitute a closed figure.

In some embodiments, the fixing portion and the first opening have a gap therebetween.

In some embodiments, the first bonding sub-portion extends in a first direction, the first bonding sub-portion and the first main body sub-portion are disposed at intervals in a second direction, and the first direction intersects the second direction. In the second direction, a minimum distance between the fixing portion and a side wall of the first opening is d1, where 0 mm < d1 ≤ 0.3 mm.

In some embodiments, the first bonding sub-portion extends in a first direction, the first bonding sub-portion and the first main body sub-portion are disposed at intervals in a second direction, and the first direction intersects the second direction. In the first direction, a minimum distance between the fixing portion and a side wall of the first opening is d2, where 0 mm < d2 ≤ 0.5 mm.

In some embodiments, the display module further includes a third sealing portion, and the third sealing portion wraps a side surface of the first bonding sub-portion away from the first main body sub-portion.

In another aspect, a method for manufacturing a display substrate is provided. The method includes: providing a display panel, where the display panel includes a display portion, a bending portion and a bonding portion connected in sequence, the display portion has a light-exit surface and a non-light-exit surface that are disposed opposite to each other, an end of the bending portion connected to the bonding portion is bent to the non-light-exit surface, the bonding portion is located on the non-light-exit surface, and the bonding portion includes a first bonding sub-portion and a first main body sub-portion that are connected to each other; forming adhesive layer(s) on the first main body sub-portion; bonding a chip onto the first main body sub-portion; bonding a flexible circuit board onto the first bonding sub-portion, where the flexible circuit board includes a second bonding sub-portion and a second main body sub-portion that are connected to each other, an orthographic projection of the second bonding sub-portion on the display portion at least partially overlaps with an orthographic projection of the first bonding sub-portion on the display portion, an orthographic projection of the second main body sub-portion on the display portion at least partially overlaps with an orthographic projection of the first main body sub-portion on the display portion, the second main body sub-portion has first opening(s), the chip is located in a first opening, and an adhesive layer and the first bonding sub-portion are located on different sides of the first opening; forming a first sealing portion in the first opening, where at least part of the first sealing portion is located on a side of the chip proximate to the first bonding sub-portion, and the first sealing portion is connected to the adhesive layer and the first main body sub-portion; and forming a second sealing portion outside the first opening, where the second sealing portion is connected to the adhesive layer, the first bonding sub-portion, the first main body sub-portion, the second bonding sub-portion and the second main body sub-portion. Orthographic projections of the first sealing portion, the adhesive layer, the second sealing portion and the first bonding sub-portion on the display portion constitute a closed figure.

In some embodiments, the method further includes: forming a third sealing portion on a side surface of the first bonding sub-portion away from the first main body sub-portion.

In some embodiments, before bonding the flexible circuit board onto the first bonding sub-portion, the method further includes: forming a fixing portion around the chip, wherein the fixing portion is connected to the chip and the first main body sub-portion.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art may obtain other drawings according to these drawings. In addition, the accompanying drawings to be described below may be regarded as schematic diagrams, but are not limitations on an actual size of a product and an actual process of a method to which the embodiments of the present disclosure relate.
FIG. 1 is a structural diagram of a display apparatus, in accordance with some embodiments;
FIG. 2 is a structural diagram of a display module, in accordance with some embodiments;
FIG. 3 is a structural diagram of another display module, in accordance with some embodiments;
FIG. 4 is a sectional view showing a structure of the display module shown in FIG. 3 taken along the A-A' direction;
FIG. 5 is a sectional view showing a structure of the display module shown in FIG. 3 taken along the B-B' direction;
FIG. 6 is a structural diagram of another display module, in accordance with some embodiments;
FIG. 7 is a sectional view showing a structure of the display module shown in FIG. 6 taken along the C-C' direction;
FIG. 8 is a structural diagram of another display module, in accordance with some embodiments;
FIG. 9 is a structural diagram of another display module, in accordance with some embodiments;
FIG. 10 is a structural diagram of another display module, in accordance with some embodiments;
FIG. 11 is a flow diagram of a method for manufacturing a display module, in accordance with some embodiments;
FIGS. 12A to 17 are structural diagrams corresponding to all steps in a method for manufacturing a display module, in accordance with some embodiments; and
FIG. 18 is a structural diagram of another display module, in accordance with some embodiments.

### DETAILED DESCRIPTION

Technical solutions in some embodiments of the present disclosure will be described clearly and completely with reference to the accompanying drawings below. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as open and inclusive, i.e., "including, but not limited to". In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described herein may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, features defined with "first" or "second" may explicitly or implicitly include one or more of the features. In the description of the embodiments of the present disclosure, the term "a plurality of" or "the plurality of" means two or more unless otherwise specified.

In the description of some embodiments, the expressions "coupled" and "connected" and derivatives thereof may be used. The term "connection" should be understood in a broad sense. For example, the "connection" may be a fixed connection, a detachable connection, or of an integral structure; it may be a direct connection or an indirect connection by an intermediate medium. The term "coupled" indicates, for example, that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the content herein.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

It will be understood that when a layer or element is referred to as being on another layer or substrate, the layer or element may be directly on the another layer or substrate, or there may be intermediate layer(s) between the layer or element and the another layer or substrate.

Exemplary embodiments are described herein with reference to sectional views and/or plane views as idealized exemplary drawings. In the accompanying drawings, thicknesses of layers and sizes of areas/regions are enlarged for clarity. Variations in shapes relative to the accompanying drawings due to, for example, manufacturing technologies and/or tolerances may be envisaged. Therefore, the exemplary embodiments should not be construed to be limited to the shapes of areas/regions shown herein, but to include deviations in the shapes due to, for example, manufacturing. For example, an etched area/region shown in a rectangular shape generally has a feature of being curved. Therefore, the areas/regions shown in the accompanying drawings are schematic in nature, and their shapes are not intended to show actual shapes of the areas/regions in a device, and are not intended to limit the scope of the exemplary embodiments.

Some embodiments of the present disclosure provide a display apparatus. For example, the display apparatus may be any apparatus that displays images whether in motion (such as a video) or fixed (such as a still image), and regardless of text or image. More specifically, it is expected that the display apparatus in the described embodiments may be implemented in or associated with a variety of electronic devices. The variety of electronic devices may include (but are not limited to), for example, mobile phones, wireless devices, personal digital assistants (PDAs), hand-held or portable computers, global positioning system (GPS) receivers/navigators, cameras, MPEG-4 Part 14 (MP4) video players, video cameras, game consoles, watches, clocks, calculators, TV monitors, flat-panel displays, computer monitors, car displays (e.g., odometer displays), navigators, cockpit controllers and/or displays, camera view displays (e.g., display of rear view camera in vehicles), electronic photos, electronic billboards or signs, projectors, architectural structures, packaging and aesthetic structures (e.g., displays for displaying an image of a piece of jewelry), etc.

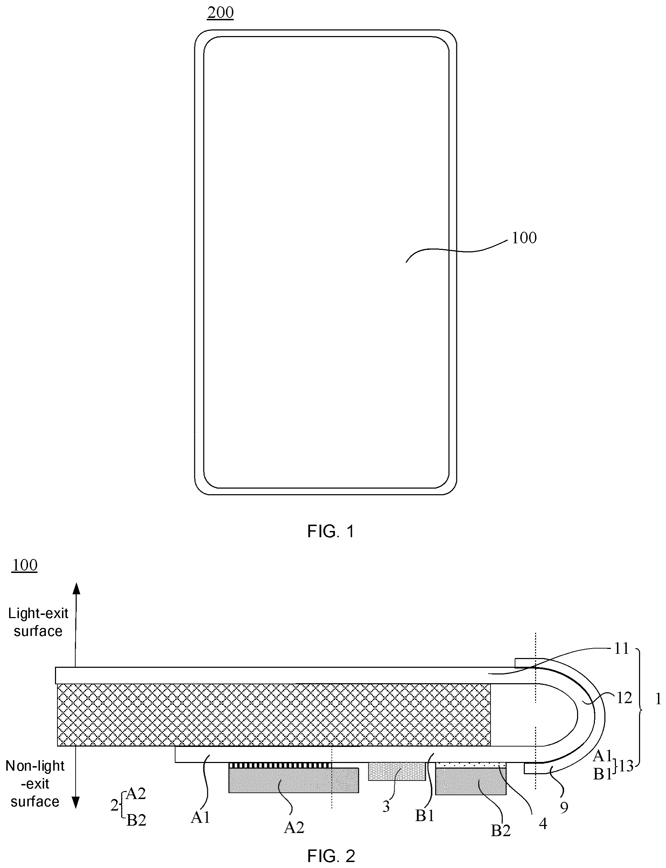

FIG. 1 is a structural diagram of a display apparatus in accordance with some embodiments. As shown in FIG. 1, the display apparatus 200 includes a display module 100.

For example, the display apparatus 200 further includes a frame, a display driver integrated circuit (IC), and other electronic components.

As shown in FIG. 2, some embodiments of the present disclosure provide a display module 100, and the display module 100 may be applied to the above display apparatus 200. Of course, the display module 100 may also be applied to other display apparatuses, which is not limited in the present disclosure.

In some embodiments, as shown in FIG. 2, the display module 100 includes a display panel 1, a flexible circuit board 2 and a chip 3.

For example, the display panel 1 may be an organic light-emitting diode (OLED) display panel, a quantum dot light-emitting diode (QLED) display panel, or the like, which is not specifically limited in the embodiments of the present disclosure.

The description will be made in an example where the display panel 1 is an OLED display panel in the present disclosure.

In some examples, as shown in FIG. 2, the display panel 1 includes a display portion 11, a bending portion 12 and a bonding portion 13 that are connected in sequence.

For example, the display portion 11 includes a plurality of pixel circuits and a plurality of light-emitting devices. The plurality of pixel circuits and the plurality of light-emitting devices may be, for example, electrically connected in one-to-one correspondence. Each pixel circuit may control the corresponding light-emitting device to emit light, and the plurality of light-emitting devices cooperate to enable the display portion 11 to display images.

As shown in FIG. 2, the display portion 11 has a light-exit surface and a non-light-exit surface that are opposite to each other. A surface of the display portion 11 for displaying images is the light-exit surface of the display portion 11, and a surface thereof facing away from the light-exit surface of the display portion 11 is the non-light-exit surface of the display portion 11.

It can be understood that a bending process may be used to bend the bending portion 12, an end of the bending portion 12 connected to the bonding portion 13 is bent to the non-light-exit surface of the display portion 11, and the bonding portion 13 is bent to the non-light-exit surface of the display portion 11. In this way, a space occupied by the display module 100 in a first direction may be reduced, and a size of the frame of the display module 100 may be reduced, so as to facilitate realization of the narrow frame design.

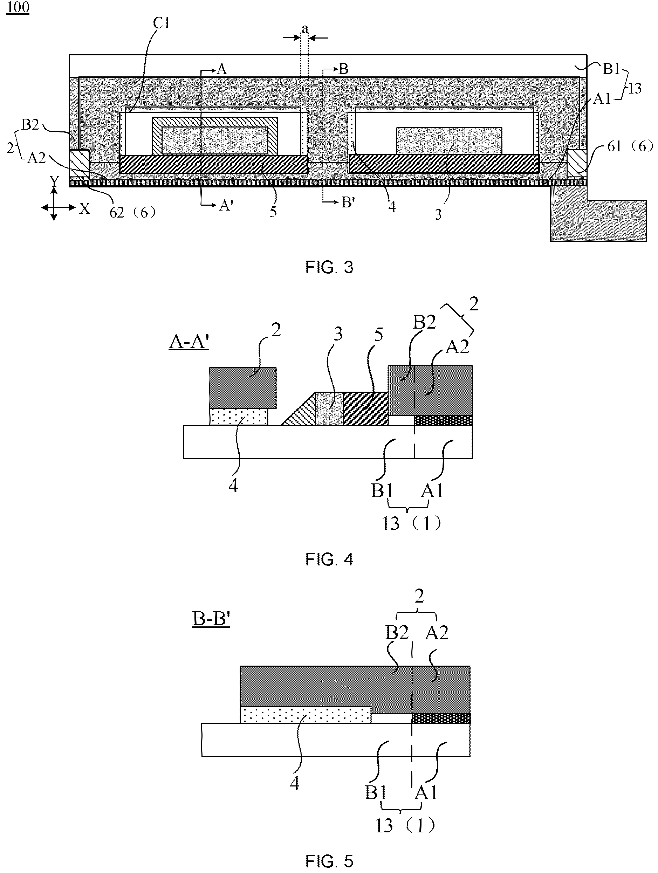

In some examples, as shown in FIGS. 2 and 3, the bonding portion 13 includes a first bonding sub-portion A1 and a first main body sub-portion B1 that are connected to each other. The flexible circuit board 2 includes a second bonding sub-portion A2 and a second main body sub-portion B2 that are connected to each other.

For example, as shown in FIG. 3, in the bonding portion 13, the first bonding sub-portion A1 extends in the first direction X, and the first bonding sub-portion A1 and the first main body sub-portion B1 are arranged in sequence in a second direction Y. In the flexible circuit board 2, the second bonding sub-portion A2 extends in the first direction X, and the second bonding sub-portion A2 and the second main body sub-portion B2 are arranged in sequence in the second direction Y.

For example, the second direction Y intersects the first direction X. Here, an included angle between the first direction X and the second direction Y may be set according to actual needs. For example, the first direction X and the second direction Y are perpendicular, that is, the included angle between the first direction X and the second direction Y is 90°.

The second bonding sub-portion A2 is bonded to the first bonding sub-portion A1, that is, the flexible circuit board 2 is bonded to the display panel 1. Thus, the flexible circuit board 2 may provide signals and the like for the display panel 1, so that the display panel 1 can realize a display function.

For example, in a case where the display portion 11 only has a display function, the flexible circuit board 2 may be used to transmit display signals required by the display portion 11. In a case where the display portion 11 has both a display function and a touch function, the flexible circuit board 2 may be used to transmit display signals or touch signals required by the display portion 11.

It can be understood that the above display signals or touch signals are transmitted to the display portion 11 through the bonding portion 13 and the bending portion 12 in sequence, so that the display portion 11 may work normally.

In some examples, as shown in FIG. 3, an orthographic projection of the second main body sub-portion B2 on the display portion 11 at least partially overlaps with an orthographic projection of the first main body sub-portion B1 on the display portion 11. For example, the orthographic projection of the second main body sub-portion B2 on the display portion 11 is located within the orthographic projection of the first main body sub-portion B1 on the display portion 11.

In some examples, as shown in FIG. 3, an orthographic projection of the second bonding sub-portion A2 on the display portion 11 at least partially overlaps with an orthographic projection of the first bonding sub-portion A1 on the display portion 11. For example, the orthographic projection of the second bonding sub-portion A2 on the display portion 11 is located within the orthographic projection of the first bonding sub-portion A1 on the display portion 11.

In the related art, the second bonding sub-portion A2 of the flexible circuit board 2 is closer to the bending portion 12 than the second main body sub-portion B2. In the first direction X, the second main body sub-portion B2 occupies part of the space separately (that is, the second main body sub-portion B2 and the first main body sub-portion B1 are disposed in a staggered manner, and the second main body sub-portion B2 and the first main body sub-portion B1 each occupy part of the space). As a result, the flexible circuit board 2 occupies a large space in the first direction. In the technical solution of the present disclosure, reverse bonding is adopted so that the second main body sub-portion B2 is closer to the bending portion 12 than the second bonding sub-portion A2, and spaces occupied by the second main body sub-portion B2 and the first main body sub-portion B1 in the first direction X overlap partially, thereby reducing the occupied space.

In this case, in the display module 100, spaces occupied by the first bonding sub-portion A1 of the bonding portion 13 and the second bonding sub-portion A2 of the flexible circuit board 2 in the first direction X overlap partially, and spaces occupied by the first main body sub-portion B1 of the bonding portion 13 and the second main body sub-portion B2 of the flexible circuit board 2 in the first direction X overlap partially, thereby realizing reverse bonding. As a result, the space occupied by the flexible circuit board 2 and the bonding portion 13 in the first direction may be reduced, and the size of the frame of the display module 100 may be reduced, so as to facilitate realization of the narrow frame design.

In some examples, as shown in FIG. 3, the second main body sub-portion B2 has first opening(s) C1. There may be one or more first openings C1. For example, as shown in FIG. 3, the number of the first opening(s) C1 is two.

For example, as shown in FIG. 3, a chip 3 is located in a first opening C1, and the chip 3 is electrically connected to the first main body sub-portion B1. Compared with a case that the chip 3 and the flexible circuit board 2 are arranged side by side in the first direction X, the chip 3 is provided in the first opening C1 of the flexible circuit board 2 in the present embodiments, and thus the space occupation of the chip 3 in the first direction may be eliminated, thereby further freeing up the space of the whole device.

For example, the chip 3 may be used to output signals to the display panel 1. For example, the chip 3 may provide the display panel 1 with data signals required for displaying images, and the data signals cooperate with other signals output by the flexible circuit board 2, so that the display panel 1 achieves display of images.

For example, the number of the chip(s) 3 is the same as the number of the first opening(s) C1, and the chip(s) 3 and the first opening(s) C1 are disposed in one-to-one correspondence, that is, a chip 3 is located in a first opening C1. Optionally, in a case where the number of the chip(s) 3 is one, the number of the first opening(s) C1 is also one; and in a case where the number of the chip(s) 3 is two, the number of the first opening(s) C1 is also two. As another example, the number of the chip(s) 3 is different from the number of the first opening(s) C1, and a plurality of chips 3 may be disposed in a first opening C1. The embodiments of the present disclosure are not limited thereto.

In some examples, as shown in FIGS. 2 and 5, the display module 100 further includes adhesive layer(s) 4. A material of the adhesive layer 4 is a material with a certain stickiness. For example, the material with the stickiness is pressure sensitive adhesive (PSA).

In combination with FIGS. 2 to 5, the adhesive layer 4 is bonded between the first main body sub-portion B1 and the second main body sub-portion B2, and is located on at least one side of the chip 3. That is, the first main body sub-portion B1 and the second main body sub-portion B2 are stuck together by the adhesive layer 4, so that the flexible circuit board 2 may be well fixed on the bonding portion 13.

For example, the adhesive layer 4 may be located on one side or multiple sides of the chip 3. For example, as shown in FIG. 3, the adhesive layer 4 is located on three sides of the chip 3.

The adhesive layer 4 and the first bonding sub-portion A1 are located on different sides of the first opening C1.

For example, in the second direction Y, the first bonding sub-portion A1 is located on a side of the first opening C1 proximate to the second bonding sub-portion A2. In this case, the adhesive layer 4 may be located on one side of the first opening C1, for example, the adhesive layer 4 is located on any side of two opposite sides of the first opening C1 in the first direction X; alternatively, the adhesive layer 4 may be located on both sides of the first opening C1, for example, the adhesive layer 4 is located on both sides of the first opening C1 in the first direction X.

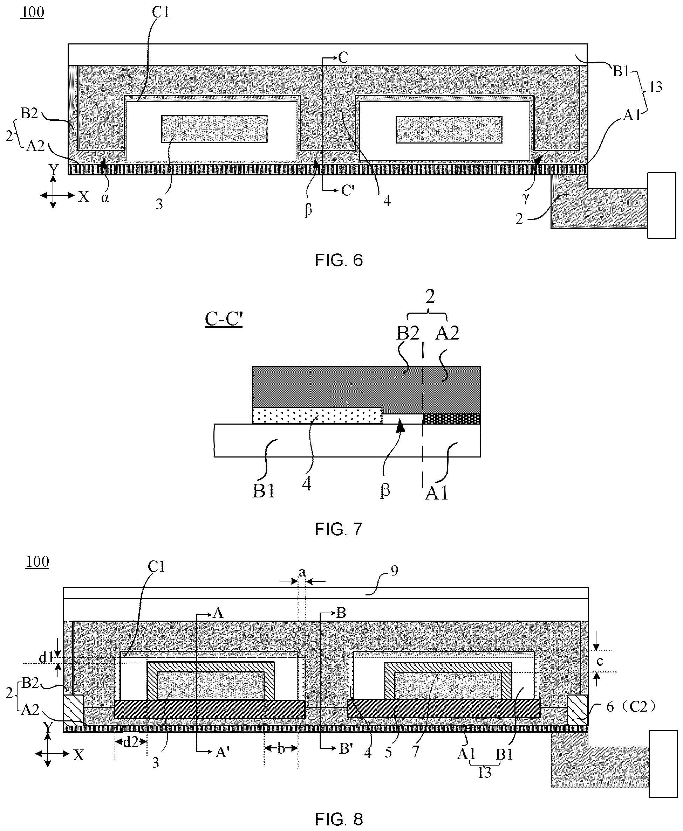

For example, as shown in FIGS. 3 and 6, in order to reduce difficulty of attaching the adhesive layer 4 and avoid affecting a bonding effect between the first bonding sub-portion A1 and the second bonding sub-portion A2 due to adhesion of the adhesive layer 4 to the first bonding sub-portion A1, there is usually a certain safety distance between the adhesive layer 4 and the first bonding sub-portion A1, that is, there is a gap (e.g., a region α, a region β and a region γ shown in FIG. 6; and a region β shown in FIG. 7) between the adhesive layer 4 and the first bonding sub-portion A1.

After the first bonding sub-portion A1 and the second bonding sub-portion A2 are bonded, and the first main body sub-portion B1 and the second main body sub-portion B2 are stuck by the adhesive layer 4, since the adhesive layer 4 has a certain thickness, a closed cavity cannot be formed at the above gap, and moisture and oxygen in the air will easily enter through the gap to corrode a bonding position between the first bonding sub-portion A1 and the second bonding sub-portion A2, thereby affecting the bonding effect between the first bonding sub-portion A1 and the second bonding sub-portion A2, and further affecting a display effect of the display module 100.

Based on this, as shown in FIG. 3, the display module 100 in the present disclosure further includes a first sealing portion 5 and a second sealing portion 6.

For example, as shown in FIG. 3, the first sealing portion 5 is located in the first opening C1, and at least part of the first sealing portion 5 is located on a side of the chip 3 proximate to the first bonding sub-portion A1. The first sealing portion 5 is connected to the adhesive layer 4, the first main body sub-portion B1 and the second main body sub-portion B2.

For example, as shown in FIG. 3, in a case where the adhesive layer 4 is located on three sides of the chip 3, the first sealing portion 5 is located in the first opening C1 and located on a side of the chip 3 proximate to the first bonding sub-portion A1. In this case, in the second direction Y, an end surface of the above gap proximate to the first opening C1 is blocked by the adhesive layer 4. Thus, moisture and oxygen may be prevented from entering through the end surface of the gap proximate to the first opening C1, thereby improving the corrosion problem at the bonding position between the first bonding sub-portion A1 and the second bonding sub-portion A2 due to entry of moisture and oxygen.

For example, as shown in FIG. 3, the second sealing portion 6 is located outside the first opening C1 and connected to the adhesive layer 4, the first bonding sub-portion A1, the first main body sub-portion B1, the second bonding sub-portion A2 and the second main body sub-portion B2.

For example, as shown in FIG. 3, the second sealing portion 6 is located at an end of the gap away from the first opening and blocks the end of the gap away from the first opening C1. Thus, moisture and oxygen may be prevented from entering through the end of the gap away from the first opening C1, thereby improving the corrosion problem at the bonding position between the first bonding sub-portion A1 and the second bonding sub-portion A2 due to entry of moisture and oxygen.

For example, the first sealing portion 5 and the second sealing portion 6 may be made of the same or different materials.

In a case where the materials of the first sealing portion 5 and the second sealing portion 6 are the same, the materials of the first sealing portion 5 and the second sealing portion 6 are, for example, both ultraviolet rays (UV) adhesive. In this case, the first sealing portion 5 and the second sealing portion 6 may be formed simultaneously, thereby simplifying the manufacturing process of the display module 100.

In a case where the materials of the first sealing portion 5 and the second sealing portion 6 are different, the material of the first sealing portion 5 may be, for example, UV adhesive, and the material of the second sealing portion 6 may be, for example, epoxy adhesive or modified silicone adhesive.

For example, orthographic projections of the first sealing portion 5, the adhesive layer 4, the second sealing portion 6 and the first bonding sub-portion A1 on the display portion 11 constitute a closed figure.

It will be noted that the "closed figure" refers to an image that is in a closed state in the dimension where the figure is located. Specifically, in the embodiments of the present disclosure, for example, as shown in FIG. 3, the first sealing portion 5 extends in the first direction X. In the first direction X, a left end surface of the first sealing portion 5 is connected to an end surface, proximate to the first opening C1, of a portion of the adhesive layer 4 located on a left side of the first opening C1; and a right end surface of the first sealing portion 5 is connected to an end surface, proximate to the first opening C1, of a portion of the adhesive layer 4 located on a right side of the first opening C1. The second sealing portion 6 extends in the second direction Y. In the second direction Y, an upper end surface of a first sub-portion 61 of the second sealing portion 6 is connected to another end surface of the portion of the adhesive layer 4 located on the right side of the first opening C1, a lower end surface of the first sub-portion 61 of the second sealing portion 6 is connected to a right end surface of the first bonding sub-portion A1, a left end surface of the first bonding sub-portion A1 is connected to a lower end surface of a second sub-portion 62 of the second sealing portion 6, and an upper end surface of the second sub-portion 62 of the second sealing portion 6 is connected to another end surface of the portion of the adhesive layer 4 located on the left side of the first opening C1. Therefore, the orthographic projections of the first sealing portion 5, the adhesive layer 4, the second sealing portion 6 and the first bonding sub-portion A1 on the display portion 11 constitute the closed figure.

Furthermore, the first main body sub-portion B1 and the second main body sub-portion B2 are stuck by the adhesive layer 4, and the first bonding sub-portion A1 and the second bonding sub-portion A2 are bonded. Therefore, the first sealing portion 5, the adhesive layer 4, the second sealing portion 6 and the first bonding sub-portion A1 may form a closed cavity with the first main body sub-portion B1 and the second main body sub-portion B2.

In the present embodiments, the first sealing portion 5 and the second sealing portion 6 are provided, and the orthographic projections of the first sealing portion 5, the adhesive layer 4, the second sealing portion 6 and the first bonding sub-portion A1 on the display portion 11 constitute the closed figure. Therefore, end surfaces of the gap between the adhesive layer 4 and the first bonding sub-portion A1 may be blocked, so that the first sealing portion 5, the adhesive layer 4, the second sealing portion 6 and the first bonding sub-portion A1 form a closed cavity with the first main body sub-portion B1 and the second main body sub-portion B2, and thus moisture and oxygen may be prevented from entering along the gap between the adhesive layer 4 and the first bonding sub-portion A1, and the bonding position between the first bonding sub-portion A1 and the second bonding sub-portion A2 may be effectively prevented from being corroded by moisture and oxygen, thereby improving the bonding effect between the first bonding sub-portion A1 and the second bonding sub-portion A2, and improving stability of the display module 100.

In some examples, there is a gap between the chip 3 and the adhesive layer 4. That is, there is a certain safety distance between the chip 3 and the adhesive layer 4, thereby reducing the difficulty of bonding the chip 3.

For example, as shown in FIG. 8, in the first direction X, a distance b between a side surface of the chip 3 and an edge of the adhesive layer 4 proximate to the side surface is in a range of 1.2 mm to 1.5 mm, inclusive. For example, in the first direction X, the distance b between the side surface of the chip 3 and the edge of the adhesive layer 4 proximate to the side surface is 1.2 mm, 1.25 mm, 1.3 mm, 1.4 mm, 1.5 mm, or the like. In the second direction Y, a distance c between a side surface of the chip 3 and an edge of the adhesive layer 4 proximate to the side surface is in a range of 0.9 mm to 1.2 mm, inclusive. For example, in the second direction Y, the distance c between the side surface of the chip 3 and the edge of the adhesive layer 4 proximate to the side surface is 0.9 mm, 1.0 mm, 1.1 mm, 1.15 mm, 1.2 mm, or the like.

In some embodiments, as shown in FIGS. 3 and 8, a portion of the adhesive layer 4 extends beyond a side wall of the first opening C1 and extends into the first opening C1.

For example, in a case where the adhesive layer 4 is located on one side of the chip 3, at one side wall of the first opening C1, a portion of the adhesive layer 4 extends beyond the side wall of the first opening C1 and extends into the first opening C1.

As another example, in a case where the adhesive layer 4 is located on a plurality of sides of the chip 3, at one side wall of the first opening C1, a portion of the adhesive layer 4 may extend beyond the side wall of the first opening C1 and extend into the first opening C1; or at multiple side walls of the first opening C1, portions of the adhesive layer 4 may extend beyond the side walls of the first opening C1 and extend into the first opening C1. For example, in a case where the adhesive layer 4 is located on three sides of the chip 3, as shown in FIG. 3, at two opposite side walls of the first opening C1 in the first direction X, portions of the adhesive layer 4 extend beyond the side walls of the first opening C1 and extend into the first opening C1.

In the present embodiments, the first sealing portion 5 may be overlapped on the portion(s) of the adhesive layer 4 extending beyond the first opening C1, thereby increasing a connection area between the first sealing portion 5 and the adhesive layer 4, further ensuring reliability of the connection between the first sealing portion 5 and the adhesive layer 4, and further improving airtightness of the closed cavity formed by the first sealing portion 5, the adhesive layer 4, the second sealing portion 6, the first bonding sub-portion A1, the first main body sub-portion B1 and the second main body sub-portion B2. As a result, waterproof performance at the bonding connection position between the flexible circuit board 2 and the display panel 1 may be improved, and the stability of the display module 100 may be improved.

In some embodiments, as shown in FIG. 8, a dimension a of the portion of the adhesive layer 4 extending beyond the first opening C1 is in a range of 0.3 mm to 0.5 mm, inclusive. For example, the dimension a of the portion of the adhesive layer 4 extending beyond the first opening C1 is 0.3 mm, 0.35 mm, 0.4 mm, 0.45 mm, 0.5 mm, or the like. The embodiments of the present disclosure are not limited thereto.

With the above setting, not only may a connection area between the first sealing portion 5 and the adhesive layer 4 be ensured to be sufficiently large, thereby ensuring effectiveness of the connection between the first sealing portion 5 and the adhesive layer 4, but also the adhesive layer 4 extending beyond the side wall of the first opening C1 and a portion of the adhesive layer 4 extending into the first opening C1 being not too large may ensure a certain safety distance between the chip 3 and the adhesive layer 4, thereby reducing the difficulty of bonding the chip 3.

In some embodiments, as shown in FIG. 3, the adhesive layer 4 has a cross-section in a U shape and surrounds the chip 3.

For example, the number of the chip(s) 3 is the same as the number of the adhesive layer(s) 4, and the chip(s) 3 and the adhesive layer(s) 4 are disposed in one-to-one correspondence, that is, an adhesive layer 4 surrounds a chip 3. In a case where the number of the chip(s) 3 is one, the number of the adhesive layer(s) 4 is also one; and in a case where the number of the chip(s) 3 is two, the number of the adhesive layer(s) 4 is also two.

For example, as shown in FIG. 3, the chip 3 is in a rectangular shape, and the adhesive layer 4 surrounds three sides of the chip 3. In this case, the first sealing portion 5 may be only provided on a side of the chip 3 proximate to the first bonding sub-portion A1, that is, the orthographic projections of the first sealing portion 5, the adhesive layer 4, the second sealing portion 6 and the first bonding sub-portion A1 on the display portion 11 may constitute the closed figure.

With the above provision, a design size of the first sealing portion 5 may be reduced. When the first sealing portion 5 is formed by colloid injection, the amount of colloid used may be reduced, thereby reducing production costs and shortening a production cycle.

Further, as shown in FIG. 3, the adhesive layer 4 surrounds two opposite sides of the chip 3 in the first direction X and a side of the chip 3 away from the first bonding sub-portion A1. On the two opposite sides of the chip 3 in the first direction X, there are portions of the adhesive layer 4 extending beyond the side walls of the first opening C1 and extending into the first opening C1. In the first direction X, both ends of the first sealing portion 5 are overlapped on the adhesive layer 4, thereby improving the reliability of the connection between the first sealing portion 5 and the adhesive layer 4, and further improving the airtightness of the closed cavity formed by the first sealing portion 5, the adhesive layer 4, the second sealing portion 6, the first bonding sub-portion A1, the first main body sub-portion B1 and the second main body sub-portion B2. As a result, waterproof performance at the bonding connection position between the flexible circuit board 2 and the display panel 1 may be improved, and the stability of the display module 100 may be improved.

In some embodiments, there are a plurality of first openings C1, and the adhesive layers 4 corresponding to all the first openings C1 are connected to be of an integral structure.

For example, as shown in FIGS. 3 and 8, the second main body sub-portion B has two first openings C1, and two adhesive layers 4 provided corresponding to the two first openings C1 are connected to each other to form an integral structure. For example, an overall shape of the two adhesive layers 4 is an "m" shape.

The above "integral structure" means that two connected patterns are disposed in a same layer, and the two patterns are continuous and not separated. Specifically, in the embodiments of the present disclosure, a plurality of adhesive layers 4 corresponding to all the first openings C1 have an interconnected and unseparated integral structure, thereby simplifying the manufacturing process of the adhesive layers 4, and the plurality of adhesive layers 4 may be pasted at one time, thereby simplifying the manufacturing process of the display module 100.

In some embodiments, as shown in FIGS. 3 and 8, the second main body sub-portion B2 further has second opening(s) C2. The second sealing portion 6 is located in the second opening C2 and in contact with a side wall of the second opening C2.

For example, as shown in FIGS. 3 and 8, the second main body sub-portion B2 has two second openings C2. In the first direction X, the two second openings C2 are located at both ends of the second main body sub-portion B2. In this case, the display module 100 includes two second sealing portions 6, and a second sealing portion 6 is located in a second opening C2.

With the above provision, in the first direction X, the second sealing portion 6 blocks an end surface of the gap between the adhesive layer 4 and the first bonding sub-portion A1, and the second sealing portion 6, the first sealing portion 5, the adhesive layer 4, the first bonding sub-portion A1, the first main body sub-portion B1 and the second main body sub-portion B2 form a closed cavity, and thus moisture and oxygen may be prevented from entering along the gap between the adhesive layer 4 and the first bonding sub-portion A1, and the bonding position between the first bonding sub-portion A1 and the second bonding sub-portion A2 may be effectively prevented from being corroded by moisture and oxygen, thereby improving the bonding effect between the first bonding sub-portion A1 and the second bonding sub-portion A2, and improving stability of the display module 100.

In some embodiments, an orthographic projection of the adhesive layer 4 on the display portion 11 partially overlaps with an orthographic projection of the second sealing portion 6 on the display portion 11.

For example, a portion of the adhesive layer 4 extends beyond a side wall of the second opening C2 and extends into the second opening C2, and the second sealing portion 6 is overlapped on the portion of the adhesive layer 4 extending into the second opening C2.

With the above provision, a connection area between the second sealing portion 6 and the adhesive layer 4 may increase, thereby ensuring reliability of the connection between the second sealing portion 6 and the adhesive layer 4, and further improving the airtightness of the closed cavity formed by the first sealing portion 5, the adhesive layer 4, the second sealing portion 6, the first bonding sub-portion A1, the first main body sub-portion B1 and the second main body sub-portion B2. As a result, waterproof performance at the bonding connection position between the flexible circuit board 2 and the display panel 1 may be improved, and the stability of the display module 100 may be improved.

In some embodiments, as shown in FIGS. 3 and 8, the first sealing portion 5 is further connected to the chip 3.

For example, the first sealing portion 5 is located on a side of the first opening C1 proximate to the first bonding sub-portion A1, and is filled in a gap between the chip 3 and the flexible circuit board 2. Therefore, the first sealing portion 5 may also be used to fix the chip 3 to prevent the chip 3 from falling off the display panel 1.

In some embodiments, as shown in FIG. 8, the display module 100 further includes a fixing portion 7 located in the first opening C1, and the fixing portion 7 is connected to the chip 3 and the first main body sub-portion B1.

For example, a material of the fixing portion 7 is UV adhesive, and the fixing portion 7 may be formed by coating.

For example, as shown in FIG. 8, the fixing portion 7 has a cross-section in a U shape and surrounds the chip 3. In this case, the fixing portion 7 is connected to three side surfaces of the chip 3. Of course, the fixing portion 7 may alternatively be connected to one side surface of the chip 3, or connected to two side surfaces of the chip 3, and the embodiments of the present disclosure are not limited thereto.

With the above provision, the chip 3 may be fixed by the fixing portion 7 to prevent the chip 3 from falling off the display panel 1.

In some embodiments, as shown in FIG. 8, the first sealing portion 5 is connected to the fixing portion 7, and orthographic projections of the first sealing portion 5 and the fixing portion 7 on the display portion 11 constitute a closed figure.

For example, as shown in FIG. 8, the first sealing portion 5 is located on a side of the chip 3 proximate to the first bonding sub-portion A1 and extends in the first direction X. In this case, in the first direction X, an end of the fixing portion 7 is connected to a side surface of the first sealing portion 5 proximate to the chip 3, and another end of the fixing 7 is connected to a side surface of the first sealing portion 5 proximate to the chip 3. That is, the two ends of the fixing portion 7 are connected by a portion of the first sealing portion 5, and the orthographic projections of the first sealing portion 5 and the fixing portion 7 on the display portion 11 constitute a closed figure.

The first sealing portion 5 is connected to the first main body sub-portion B1 and the chip 3. On a side of the chip 3 proximate to the first bonding sub-portion A1, the bonding position between the first main body sub-portion B1 and the chip 3 is wrapped by the first sealing portion 5. The fixing portion 7 is connected to the first main body sub-portion B1 and the chip 3. On a plurality of side surfaces of the chip 3 surrounded by the fixing portion 7, the bonding position between the first main body sub-portion B1 and the chip 3 is wrapped by the fixing portion 7.

With the above provision, the bonding connection position between the chip 3 and the first main body sub-portion B1 may be prevented from being in contact with moisture and oxygen, thereby improving waterproof performance at the bonding connection position between the chip 3 and the first main body sub-portion B1 and improving the stability of the display module 100.

In some embodiments, as shown in FIG. 8, there is a gap between the fixing portion 7 and the first opening C1.

For example, there is a gap between each position of the fixing portion 7 and the first opening C1.

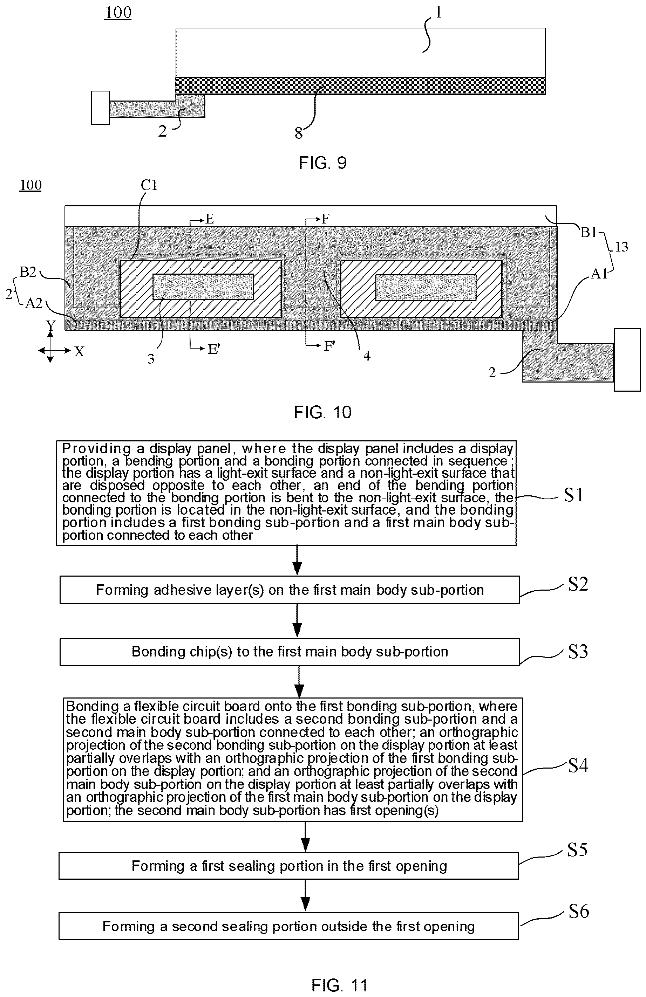

In the related art, as shown in FIG. 10, colloid is filled between the fixing portion 7 and the first opening C1. In this case, there is a large amount of colloid used, the production cost is high, and the production cycle is long.

With the above provision in the present disclosure, not only may interference and collision of the flexible circuit board 2 and the fixed portion 7 be avoided when the flexible circuit board 2 is attached, but also the amount of colloid used may be reduced, the production cost may be reduced, and the production cycle may be shortened.

In some embodiments, as shown in FIG. 8, in the second direction Y, a minimum distance between the fixing portion 7 and a side wall of the first opening C1 is d1, where 0 mm < d1 ≤ 0.3 mm. For example, in the second direction Y, the minimum distance d1 between the fixing portion 7 and the side wall of the first opening C1 is 0.05 mm, 0.1 mm, 0.15 mm, 0.2 mm or 0.3 mm, which is not limited in the embodiments of the present disclosure.

Such provision may ensure a safe distance between the chip 3 and the first opening C1 in the flexible circuit board 2, and a safe distance between the fixing portion 7 disposed around the chip 3 and the first opening C1 in the flexible circuit board 2, thereby reducing the difficulty of attaching the flexible circuit board 2, and preventing the flexible circuit board 2 from colliding with the fixing portion 7 when the flexible circuit board 2 is attached.

Further, in the second direction Y, the minimum distance d1 between the fixing portion 7 and the side wall of the first opening C1 may be in a range of 0.1 mm to 0.2 mm, inclusive. For example, in the second direction Y, the minimum distance d1 between the fixing portion 7 and the side wall of the first opening C1 is 0.1 mm, 0.12 mm, 0.14 mm, 0.17 mm or 0.20 mm, which is not limited in the embodiments of the present disclosure. In this way, a safe distance between the chip 3 and the first opening C1 in the flexible circuit board 2, and a safe distance between the fixing portion 7 disposed around the chip 3 and the first opening C1 in the flexible circuit board 2 may be ensured, and a small space reserved for the chip 3 and the fixing portion 7 disposed around the chip 3 in the flexible circuit board 2may be ensured (that is, the first opening C1 is small), thereby ensuring the performance of the flexible circuit board 2.

In some embodiments, as shown in FIG. 8, in the first direction X, a minimum distance between the fixing portion 7 and a side wall of the first opening C1 is d2, where 0 mm < d2 ≤ 0.5 mm. For example, in the first direction X, the minimum distance d2 between the fixing portion 7 and the side wall of the first opening C1 is 0.05 mm, 0.15 mm, 0.25 mm, 0.4 mm or 0.5 mm, which is not limited in the embodiments of the present disclosure.

Further, in the first direction X, the minimum distance d2 between the fixing portion 7 and the side wall of the first opening C1 may be in a range of 0.2 mm to 0.3 mm, inclusive. For example, in the first direction X, the minimum distance d2 between the fixing portion 7 and the side wall of the first opening C1 is 0.2 mm, 0.22 mm, 0.24 mm, 0.27 mm or 0.30 mm, which is not limited in the embodiments of the present disclosure. In this way, a safe distance between the chip 3 and the first opening C1 in the flexible circuit board 2, and a safe distance between the fixing portion 7 disposed around the chip 3 and the first opening C1 in the flexible circuit board 2 may be ensured, and a small space reserved for the chip 3 and the fixing portion 7 disposed around the chip 3 in the flexible circuit board 2may be ensured (that is, the first opening C1 is small), thereby ensuring the performance of the flexible circuit board 2.

Such provision may ensure a safe distance between the chip 3 and the first opening C1 in the flexible circuit board 2, and a safe distance between the fixing portion 7 disposed around the chip 3 and the first opening C1 in the flexible circuit board 2, thereby reducing the difficulty of attaching the flexible circuit board 2, and preventing the flexible circuit board 2 from colliding with the fixing portion 7 when the flexible circuit board 2 is attached.

In some embodiments, as shown in FIG. 9, the display module 100 further includes a third sealing portion 8. The third sealing portion 8 wraps a side surface of the first bonding sub-portion A1 away from the first main body sub-portion B1. Thus, the side surface of the first bonding sub-portion A1 away from the first main body sub-portion B1 may be prevented from being in contact with moisture and oxygen, thereby improving waterproof performance of the side surface of the first bonding sub-portion A1 away from the first main body sub-portion B1 and improving the stability of the display module 100.

Furthermore, the third sealing portion 8 further wraps a side surface of the second bonding sub-portion A2 away from the second main body sub-portion B2, thereby preventing the side surface of the second bonding sub-portion A2 away from the second main body sub-portion B2 from being in contact with moisture and oxygen, improving waterproof performance of the side surface of the second bonding sub-portion A2 away from the second main body sub-portion B2 and improving the stability of the display module 100.

In some examples, as shown in FIGS. 2 and 8, the display module 100 further includes a micro coating layer 9.

For example, the micro coating layer 9 is located on an outer side of the bending portion 12 of the display panel 1 and is used to protect the bending portion 12 of the display panel 1.

For example, a material of the micro coating layer 9 is metal cover layer (MCL) adhesive.

The present disclosure further provides a method for manufacturing a display module 100, which is used to manufacture the display substrate 100 mentioned above. As shown in FIG. 11, the method for manufacturing the display module 100 includes steps S1 to S6.

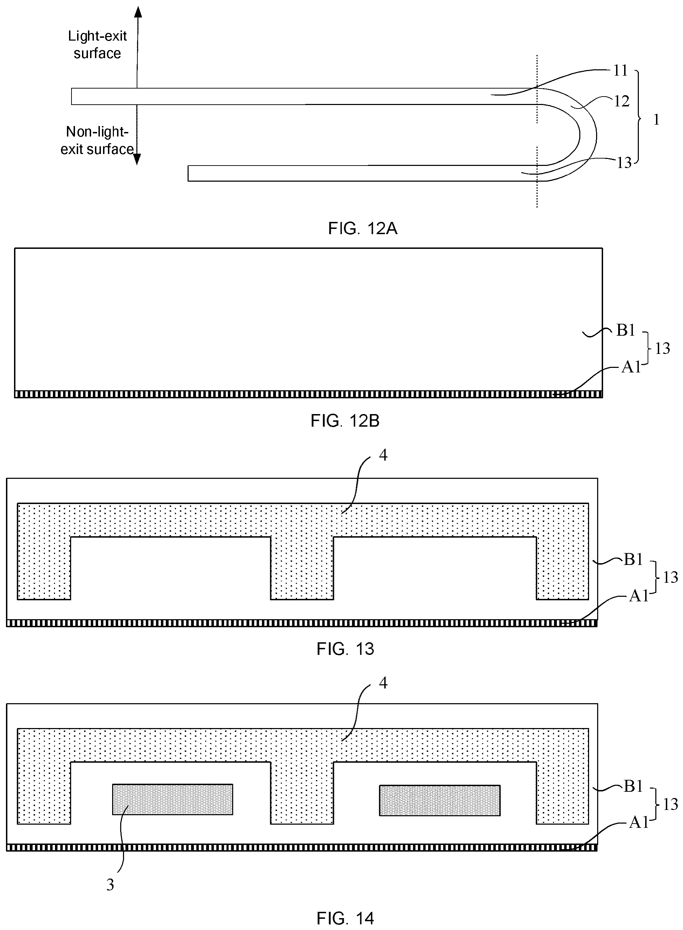

In S1, as shown in FIGS. 12A and 12B, a display panel 1 is provided. The display panel 1 includes a display portion 11, a bending portion 12 and a bonding portion 13 connected in sequence. The display portion 11 has a light-exit surface and a non-light-exit surface that are disposed opposite to each other, an end of the bending portion 12 connected to the bonding portion 13 is bent to the non-light-exit surface of the display portion 11, and the bonding portion 13 includes a first bonding sub-portion A1 and a first main body sub-portion B1 that are connected to each other.

In S2, as shown in FIG. 13, adhesive layer(s) 4 are formed on the first main body sub-portion B1.

For example, for a structure of the adhesive layer 4, reference may be made to the description in some of the above embodiments, and details are not repeated here.

In S3, as shown in FIG. 14, chip(s) 3 are bonded to the first main body sub-portion B1.

For example, for a structure of the chip 3, reference may be made to the description in some of the above embodiments, and details are not repeated here.

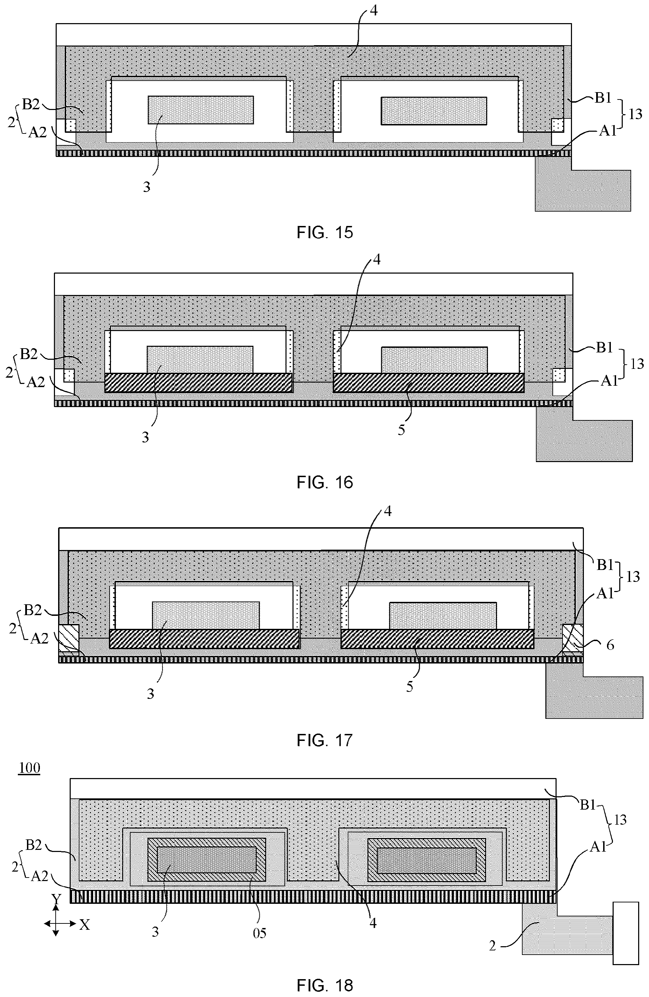

In S4, as shown in FIG. 15, a flexible circuit board 2 is bonded onto the first bonding sub-portion A1. The flexible circuit board 2 includes a second bonding sub-portion A2 and a second main body sub-portion B2 that are connected to each other. An orthographic projection of the second bonding sub-portion A2 on the display portion 11 at least partially overlaps with an orthographic projection of the first bonding sub-portion A1 on the display portion 11; and an orthographic projection of the second main body sub-portion B2 on the display portion 11 at least partially overlaps with an orthographic projection of the first main body sub-portion B1 on the display portion 11. The second main body sub-portion B2 has first opening(s) C1.

For example, the chip 3 is located in the first opening C1, and the adhesive layer 4 and the first bonding sub-portion A1 are located on different sides of the first opening C1.

In S5, as shown in FIG. 16, a first sealing portion 5 is formed in the first opening C1.

For example, for a structure of the first sealing portion 5, reference may be made to the description in some of the above embodiments, and details are not repeated here.

For example, the first sealing portion 5 is formed by colloid injection.

In S6, as shown in FIG. 17, a second sealing portion 6 is formed outside the first opening C1.

For example, for a structure of the second sealing portion 6, reference may be made to the description in some of the above embodiments, and details are not repeated here.

For example, the second sealing portion 6 is formed by colloid injection.

It will be noted that, some of the steps in the above manufacturing method may be performed simultaneously or performed in an order different from that shown in FIG. 11. For example, the above steps S5 and S6 may be performed in reverse, that is, the second sealing portion 6 is formed outside the first opening C1, and then the first sealing portion 5 is formed inside the first opening C1; alternatively, the above steps S5 and S6 may be performed simultaneously, that is, the second sealing portion 6 is formed outside the first opening C1, and simultaneously, the first sealing portion 5 is formed inside the first opening C1.

For example, orthographic projections of the first sealing portion 5, the adhesive layer 4, the second sealing portion 6 and the first bonding sub-portion A1 on the display portion 11 constitute a closed figure.

The method for manufacturing the display module 100 provided in some embodiments of the present disclosure may be used to manufacture the display module 100 in any of the above embodiments. In the manufacturing method, after the flexible circuit board 2 is bonded to the first bonding sub-portion A1, the first sealing portion 5 is formed in the first opening C1 of the flexible circuit board 2 to block an end surface, proximate to the first opening C1, of a gap between the adhesive layer 4 and the first bonding sub-portion A1, and the second sealing portion 6 is formed outside the first opening C1 to block an end surface, away from the first opening C1, of the gap between the adhesive layer 4 and the first bonding sub-portion A1. As a result, the first sealing portion 5, the adhesive layer 4, the second sealing portion 6 and the first bonding sub-portion A1, together with the first main body sub-portion B1 and the second main body sub-portion B2, form a closed cavity, and thus moisture and oxygen may be prevented from entering along the gap between the adhesive layer 4 and the first bonding sub-portion A1, and a bonding position between the first bonding sub-portion A1 and the second bonding sub-portion A2 may be effectively prevented from being corroded by moisture and oxygen, thereby improving a bonding effect between the first bonding sub-portion A1 and the second bonding sub-portion A2, and improving stability of the display module 100.

In some embodiments, the method for manufacturing the display module 100 further includes: forming a third sealing portion 8 on a side surface of the first bonding sub-portion A1 away from the first main body sub-portion B1.

For example, the third sealing portion 8 wraps a side surface of the first bonding sub-portion A1 away from the first main body sub-portion B1. Thus, the side surface of the first bonding sub-portion A1 away from the first main body sub-portion B1 may be prevented from being in contact with moisture and oxygen, thereby improving waterproof performance of the side surface of the first bonding sub-portion A1 away from the first main body sub-portion B1 and improving the stability of the display module 100.

Furthermore, the third sealing portion 8 further wraps a side surface of the second bonding sub-portion A2 away from the second main body sub-portion B2, thereby preventing the side surface of the second bonding sub-portion A2 away from the second main body sub-portion B2 from being in contact with moisture and oxygen, improving waterproof performance of the side surface of the second bonding sub-portion A2 away from the second main body sub-portion B2 and improving the stability of the display module 100.

In some embodiments, before the above step S4, the method for manufacturing the display module 100 further includes: forming a fixing portion 7 around the chip 3, where the fixing portion 7 is connected to the chip 3 and the first main body sub-portion B1.

For example, a material of the fixing portion 7 is UV adhesive, and the fixing portion 7 may be formed by coating.

For example, as shown in FIG. 8, the fixing portion 7 has a cross-section in a U shape and surrounds the chip 3. For example, in the first direction X, two opposite side surfaces of the chip 3 and a side surface of the chip 3 away from the first bonding sub-portion A are surrounded by the fixing portion 7.

In the related art, as shown in FIG. 18, a blind hole is provided on a side of the flexible circuit board 2 proximate to the bonding portion 13. The chip 3 is located in the blind hole, and a side adhesive 05 is applied by coating around the chip 3 to fix the chip 3. Therefore, during manufacturing the display module 100, the flexible circuit board 2 needs to be attached after the chip 3 is electrically connected to the first main body sub-portion B1 and the chip 3 is fixed.

In this case, when the side adhesive 05 is applied by coating around the chip 3, colloid on a side surface of the chip 3 proximate to the first bonding sub-portion A1 is easily splashed onto the first bonding sub-portion A1; and thus when the second bonding sub-portion A2 is subsequently bonded to the first bonding sub-portion A1, abnormal bonding between the second bonding sub-portion A2 and the first bonding sub-portion A1 is likely to occur, resulting in abnormal display of the display module 100. Moreover, when the flexible circuit board 2 is attached, since the side adhesive 05 has been formed around the chip 3, a safety distance between the side adhesive 05 and the flexible circuit board 2 is small, and the side adhesive 05 and the flexible circuit board 2 are prone to collision.

In the above disclosed embodiments, before the flexible circuit board 2 is bonded, the fixing portion 7 is formed around the chip 3; and after the flexible circuit board 2 is bonded and after the flexible circuit board 2 is bonded to the display panel 1, the first sealing portion 5 is formed on a side surface of the chip 3 proximate to the first bonding sub-portion A1 of the display panel 1. Therefore, when the flexible circuit board 2 is bonded, the side surface of the chip 3 proximate to the first bonding sub-portion A1 and the flexible circuit board 2 have a large safety distance therebetween, thereby reducing the difficulty of attaching the flexible circuit board 2 and reducing a probability of interference and collision between the flexible circuit board 2 and the side adhesive around the chip 3. Moreover, it may also avoid abnormal display of the display module 100 caused by abnormal bonding between the second bonding sub-portion A2 of the flexible circuit board 2 and the first bonding sub-portion A1 when the flexible circuit board 2 is bonded subsequently, where the abnormal bonding is caused by that part of the colloid is splashed to the first bonding sub-portion A1 when the first sealing portion 5 is formed on the side surface of the chip 3 proximate to the first bonding sub-portion A1.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display module, comprising:
a display panel including a display portion, a bending portion and a bonding portion connected in sequence, wherein the display portion has a light-exit surface and a non-light-exit surface that are disposed opposite to each other, an end of the bending portion connected to the bonding portion is bent to the non-light-exit surface; the bonding portion is located on the non-light-exit surface; and the bonding portion includes a first bonding sub-portion and a first main body sub-portion that are connected to each other;
a flexible circuit board including a second bonding sub-portion and a second main body sub-portion that are connected to each other, wherein an orthographic projection of the second bonding sub-portion on the display portion at least partially overlaps with an orthographic projection of the first bonding sub-portion on the display portion; an orthographic projection of the second main body sub-portion on the display portion at least partially overlaps with an orthographic projection of the first main body sub-portion on the display portion; and the second main body sub-portion has first opening(s);
a chip located in a first opening and electrically connected to the first main body sub-portion;
adhesive layer(s) bonded between the first main body sub-portion and the second main body sub-portion, and located on at least one side of the chip; an adhesive layer and the first bonding sub-portion being located on different sides of the first opening;
a first sealing portion located in the first opening, at least part of the first sealing portion being located on a side of the chip proximate to the first bonding sub-portion; and the first sealing portion being connected to the adhesive layer, the first main body sub-portion and the second main body sub-portion; and
a second sealing portion located outside the first opening and connected to the adhesive layer, the first bonding sub-portion, the first main body sub-portion, the second bonding sub-portion and the second main body sub-portion; wherein
orthographic projections of the first sealing portion, the adhesive layer, the second sealing portion and the first bonding sub-portion on the display portion constitute a closed figure.

2. The display module according to claim 1, wherein a portion of the adhesive layer extends beyond a side wall of the first opening and extends into the first opening.

3. The display module according to claim 2, wherein a dimension of the portion of the adhesive layer extending beyond the first opening is in a range of 0.3 mm to 0.5 mm, inclusive.

4. The display module according to any one of claims 1 to 3, wherein the adhesive layer has a cross-section in a U shape and surrounds the chip.

5. The display module according to any one of claims 1 to 4, wherein the first opening(s) include a plurality of first openings, and adhesive layers corresponding to all first openings are connected to be of an integral structure.

6. The display module according to any one of claims 1 to 5, wherein the second main body sub-portion further has a second opening, and the second sealing portion is located in the second opening and in contact with a side wall of the second opening.

7. The display module according to any one of claims 1 to 6, wherein an orthographic projection of the adhesive layer on the display portion partially overlaps with an orthographic projection of the second sealing portion on the display portion.

8. The display module according to any one of claims 1 to 7, wherein the first sealing portion is further connected to the chip.

9. The display module according to claim 8, further comprising a fixing portion located in the first opening, wherein the fixing portion is connected to the chip and the first main body sub-portion.

10. The display module according to claim 9, wherein the first sealing portion is connected to the fixing portion, and orthographic projections of the first sealing portion and the fixing portion on the display portion constitute a closed figure.

11. The display module according to claim 9 or 10, wherein the fixing portion and the first opening have a gap therebetween.

12. The display module according to claim 11, wherein the first bonding sub-portion extends in a first direction, the first bonding sub-portion and the first main body sub-portion are disposed at intervals in a second direction, and the first direction intersects the second direction; and
in the second direction, a minimum distance between the fixing portion and a side wall of the first opening is d1, wherein 0 mm < d1 ≤ 0.3 mm.

13. The display module according to claim 11 or 12, wherein the first bonding sub-portion extends in a first direction, the first bonding sub-portion and the first main body sub-portion are disposed at intervals in a second direction, and the first direction intersects the second direction; and
in the first direction, a minimum distance between the fixing portion and a side wall of the first opening is d2, wherein 0 mm < d2 ≤ 0.5 mm.

14. The display module according to any one of claims 1 to 13, further comprising: a third sealing portion, wherein the third sealing portion wraps a side surface of the first bonding sub-portion away from the first main body sub-portion.

15. A method for manufacturing a display module, comprising:
providing a display panel, wherein the display panel includes a display portion, a bending portion and a bonding portion connected in sequence; the display portion has a light-exit surface and a non-light-exit surface that are disposed opposite to each other, an end of the bending portion connected to the bonding portion is bent to the non-light-exit surface; the bonding portion is located on the non-light-exit surface; and the bonding portion includes a first bonding sub-portion and a first main body sub-portion that are connected to each other;
forming adhesive layer(s) on the first main body sub-portion;
bonding a chip onto the first main body sub-portion;
bonding a flexible circuit board onto the first bonding sub-portion, wherein the flexible circuit board includes a second bonding sub-portion and a second main body sub-portion that are connected to each other; an orthographic projection of the second bonding sub-portion on the display portion at least partially overlaps with an orthographic projection of the first bonding sub-portion on the display portion; an orthographic projection of the second main body sub-portion on the display portion at least partially overlaps with an orthographic projection of the first main body sub-portion on the display portion; the second main body sub-portion has first opening(s); the chip is located in a first opening, and an adhesive layer and the first bonding sub-portion are located on different sides of the first opening;
forming a first sealing portion in the first opening, wherein at least part of the first sealing portion is located on a side of the chip proximate to the first bonding sub-portion; and the first sealing portion is connected to the adhesive layer and the first main body sub-portion; and
forming a second sealing portion outside the first opening, wherein the second sealing portion is connected to the adhesive layer, the first bonding sub-portion, the first main body sub-portion, the second bonding sub-portion and the second main body sub-portion; wherein
orthographic projections of the first sealing portion, the adhesive layer, the second sealing portion and the first bonding sub-portion on the display portion constitute a closed figure.

16. The method according to claim 15, further comprising: forming a third sealing portion on a side surface of the first bonding sub-portion away from the first main body sub-portion.

17. The method according to claim 15 or 16, wherein before bonding the flexible circuit board onto the first bonding sub-portion, the method further comprises:
forming a fixing portion around the chip, wherein the fixing portion is connected to the chip and the first main body sub-portion.

18. A display apparatus, comprising the display module according to any one of claims 1 to 14.
